# EUROPÄISCHE PATENTSCHRIFT

(11) **EP 0 412 602 B1**
(45) Veröffentlichungstag und Bekanntmachung des Hinweises auf die Patenterteilung: **08.01.1997**
(21) Anmeldenummer: 90202090.8
(22) Anmeldetag: 31.07.1990
(51) Int. Cl.: G01R 33/485, G01R 33/54

(54) **Kernresonanz-Spektroskopieverfahren und Anordnung zur Durchführung des Verfahrens**
NMR spectroscopic method and apparatus for using it
Procédé de spectroscopie RMN et dispositif pour sa mise en oeuvre

(30) Priorität: 05.08.1989 DE 3925972
(43) Veröffentlichungstag der Anmeldung: 13.02.1991
(73) Patentinhaber: Philips Patentverwaltung GmbH, 22335 Hamburg (DE); Philips Electronics N.V., 5621 BA Eindhoven (NL)
(72) Erfinder: McKinnon, Graeme, Dr., CH-8053 Zürich (CH); Bösiger, Peter, Dr. Priv.-Doz., CH-5400 Ennetbaden (CH)
(74) Vertreter: Hartmann, Heinrich, Dipl.-Ing.

(56) Entgegenhaltungen:
- EP-A- 0 322 006
- EP-A- 0 370 333
- US-A- 4 733 185
- MAGNETIC RESONANCE IN MEDICINE. vol. 8, no. 3, November 1988, DULUTH,MN US Seiten 355 - 361; G.C. MC KINNON ET AL.: "A one shot lactate-editing sequence for localized whole-body spectroscopy"
- CHEMICAL PHYSICS LETTERS vol. 69, no. 3, 01 Februar 1980, AMSTERDAM, HOLLAND Seiten 567 - 570; A.BAX ET AL.: "Separation of the different orders of NMR multiple-quantum transitions....."
- MAGNETIC RESONANCE IN MEDICINE. vol. 10, no. 3, Juni 1989, DULUTH,MN US Seiten 404 - 410; A. KNUETTEL ET AL.: "Double-quantum filtered volume-selective NMR spectroscopy"
- MAGNETIC RESONANCE IN MEDICINE. vol. 9, no. 2, Februar 1989, DULUTH,MN US Seiten 254 - 260; A. KNUETTEL ET AL.: "Single-scan volume-selective spectral editing by homonuclear polarization transfer"
- MAGNETIC RESONANCE IN MEDICINE. vol. 6, no. 3, März 1988, DULUTH,MN US Seiten 334 - 343; G.C. MC KINNON ET AL.: "Localized double-quantum filter and correlation spectroscopy experiments"
- MAGNETIC RESONANCE IN MEDICINE. vol. 3, no. 2, April 1986, DULUTH,MN US Seiten 282 - 288; C.L. DUMOULIN ET AL.: "Water suppression in 1H M.R.I. by the generation of multiple-quantum coherence"

## Beschreibung

Die Erfindung betrifft ein Kernspinresonanz-Spektroskopieverfahren zum Editieren der von der CH-Gruppe und der CH₃-Gruppe von Laktat herrührenden Laktatkomponenten in Gegenwart von Fettmolekülen mit einer störenden, von der CH₂-Gruppe herrührenden Lipidkomponente, bei dem in Anwesenheit eines homogenen stationären Magnetfeldes auf einen Untersuchungsbereich eine Vielzahl von Sequenzen einwirkt, von denen jede wenigstens drei Hochfrequenzimpulse umfaßt, wobei der Abstand der beiden ersten Hochfrequenzimpulse gleich dem Kehrwert des Zweifachen der skalaren Kopplungskonstante J der miteinander gekoppelten Laktatkomponenten ist und wobei zwischen bzw. nach den Impulsen magnetische Gradientenfelder mit solcher Amplitude und Dauer wirksam werden, daß nach dem dritten Hochfrequenzimpuls auftretende Kernspinresonanzsignale nur durch Doppelquantenkohärenz bestimmt sind.

Ein derartiges Verfahren ist beschrieben von D.M. Freeman, et al. SMRM Abstracts (San Francisco), 212 (1988) und von A. Bax et al, Chem.Phys.Lett., 69, 567 (1980). Bei den bekannten Verfahren wird vor und nach dem letzten Hochfrequenzimpuls ein magnetisches Gradientenfeld ein- und ausgeschaltet. Das zeitliche Integral über dieses Feld nach dem letzten Impuls ist dabei gerade doppelt so groß wie das entsprechende Integral vor diesen Impuls. Dadurch wird erreicht, daß nur Doppelquantenkohärenzen Einfluß auf das Kernresonanzsignal haben. Einfachquantenkohärenzen, insbesondere die Signale, die von an Wasser gebundenen Protonen herrühren, werden dabei stark unterdrückt.

In der Veröffentlichung von Freeman et al wird dieses Verfahren dazu eingesetzt, um die Konzentration von Milchsäure bzw. Laktat unabhängig von der Konzentration von Fett bzw. Lipiden zu bestimmen. Die Larmorfrequenzen von an Fett und von Milchsäure gebundenen Protonen liegen sehr dicht beieinander. Um diese beiden Komponenten gleichwohl voneinander trennen zu können, wird bei dem bekannten Verfahren ein zweidimensionales Frequenzspektrum erzeugt. Dazu wird die sogenannte Evolutionszeit zwischen dem zweiten und dem dritten Hochfrequenzimpuls in Stufen geändert und aus den dabei gewonnenen Kernresonanzsignalen wird durch eine zweidimensionale Fouriertransformation ein zweidimensionales Frequenzspektrum gewonnen, in dem sich Fett und Milchsäure gut voneinander trennen lassen.

Zweidimensionale Frequenzspektren erfordern sehr lange Gesamtmeßzeiten und sind gegenüber Bewegungen im Untersuchungsbereich empfindlich. Es wäre daher an sich erstrebenswert, in einem eindimensionalen Frequenzspektrum die Milchsäurekonzentration unabhängig von der Fettkonzentration bestimmen zu können. Dies wird dadurch erschwert, daß die eine Frequenzkomponente von an Milchsäure gebundenen Protonen in unmittelbarer Nähe der Larmorfrequenz von an Wasser gebundenen Protonen liegt und daß die andere Frequenzkomponente von Milchsäure einer Fettkomponente unmittelbar benachbart ist, die auch im Doppelquantenspektrum enthalten ist.

Aufgabe der vorliegenden Erfindung ist es daher, ein Verfahren der eingangs genannten Art so auszugestalten, daß die Lipidkomponente, die im Frequenzspektrum praktisch mit der Laktatkomponente zusammenfällt, wesentlich reduziert wird.

Lösungen dieser Aufgabe sind in den Ansprüchen 1 und 2 angegeben.

Die Erfindung basiert auf folgenden Überlegungen. Bei einer Sequenz nach dem eingangs erwähnten Verfahren können durch den zweiten Hochfrequenzimpuls Doppelquantenübergänge angeregt werden. Ein solcher Doppelquantenübergang ruft an sich kein meßbares Kernresonanzsignal hervor, jedoch wird dieser Doppelquantenübergang durch den dritten Hochfrequenzimpuls in einen Zustand überführt, in dem er ein meßbares Signal liefert.

Bei der Lösung nach Anspruch 1 wird der zweite Hochfrequenzimpuls in der Weise frequenzselektiv gemacht, daß Doppelquantenzustände der störenden Lipidkomponente (L₁) gar nicht erst angeregt werden bzw. nicht in einen Zustand überführt werden, in dem sie ein Kernspinresonanzsignal erzeugen.

Bei der Lösung nach Anspruch 2 wird der dritte Hochfrequenzimpuls in der Weise frequenzslektiv gemacht, daß etwaige Doppelquantenzustände der störenden Lipidkomponente (L₁) nicht in einen Zustand überführt werden können, in dem sie einen meßbaren Beitrag zum Kernresonanzsignal liefern, das infolge der drei anregenden Hochfrequenzimpulse entsteht. Darüberhinaus wird dadurch auch die Amplitude der Laktatkomponente im Spektrum vergrößert. Es sei an dieser Stelle erwähnt, daß aus der nicht vor veröffentlichten EP-A-0 370 333 bereits ein Verfahren der eingangs genannten Art bekannt ist, bei dem der dritte Hochfrequenzimpuls derart frequenzselektiv ist, daß er für die von der CH-Gruppe herrührende Laktatkomponente als 90°-Impuls wirksam ist und für die von der CH₃-Gruppe herrührende Laktatkomponente als 0°-Impuls.

Infolge der Maßnahmen nach Anspruch 1 und 2, die auch in Kombination angewandt werden können, wird im Doppelquantenspektrum die von Fett herrührende Fequenzkomponente, die sich praktisch mit der niedrigeren Frequenzkomponente von Milchsäure deckt, weitgehend unterdrückt und die Milchsäurekonzentration kann praktisch unbeeinflußt vom Fettgehalt bestimmt werden.

Für medizinische Untersuchungen am menschlichen Körper ist es wichtig, den Volumenbereich zu selektieren, der spektroskopisch erfaßt werden soll. Dies erfolgt nach einer Weiterbildung der Erfindung dadurch, daß zur Volumenselektion jede Teilsequenz im Anschluß an die drei Hochfrequenzimpulse drei weitere als 180°-Impulse wirksamen Hochfrequenzimpulse umfaßt, die mit je einem magnetischen Gradientenfeld verknüpft sind, wobei die Gradienten der bei den drei 180°-Impulsen wirksamen Gradientenfelder senkrecht zueinander verlaufen.

Ein alternatives Verfahren ist dadurch gekennzeichnet, daß zur Volumenselektion der erste Hochfrequenzimpuls, der danach vor dem zweiten Impuls erzeugte Hochfrequenzimpuls und ein vierter - vorzugsweise als 180°-Hochfrequenzimpuls ausgebildeter - auf den dritten Impuls folgender Hochfrequenzimpuls von magnetischen Gradientenfeldern begleitet werden, deren Gradienten senkrecht zueinander verlaufen.

In der medizinischen Diagnostik wird es immer wichtiger, die räumliche Verteilung von Metaboliten - insbesondere von Laktat - zu ermitteln. Dies wird nach einer Weiterbildung dadurch möglich, daß zur Bestimmung der räumlichen Laktatverteilung nach dem dritten Hochfrequenzimpuls ein vierter - vorzugsweise als 180°-Impuls ausgebildeter - von einem magnetischen Gradientenfeld begleiteter Hochfrequenzimpuls erzeugt wird, daß zwischen dem dritten und dem vierten Hochfrequenzimpuls zwei Gradienten zueinander sowie zu dem während des vierten Hochfrequenzimpulses wirksamen Gradienten senkrecht verlaufen und daß bei der Wiederholung der Sequenz das zeitliche Integral des Gradienten wenigstens eines der beiden zwischen dem dritten und dem vierten Hochfrequenzimpuls wirksamen Gradientenfelder variiert ist.

Anordnungen zur Durchführung des Verfahrens sind in den Ansprüchen 10 und 11 angegeben.

Die Erfindung wird nachstehend anhand der Zeichnung näher erläutert. Es zeigen
Fig. 1 ein Kernspintomographiegerät, mit dem die Erfindung durchführbar ist,
Fig. 2 das Blockschaltbild eines derartigen Gerätes,
Fig. 3 ein Frequenzdiagramm mit den relevanten Spektralkomponenten von Fett, Wasser und Milchsäure,
Fig. 4 den zeitlichen Verlauf der Signale bei einer ersten volumenselektiven Sequenz,
Fig. 5 den zeitlichen Verlauf des zweiten Hochfrequenzimpulses und
Fig. 6 den zeitlichen Verlauf des dritten Hochfrequenzimpulses.
Fig. 7 den zeitlichen Verlauf der Signale bei einer alternativen volumenselektiven Sequenz und
Fig. 8 eine Sequenz zum Laktat-Imaging.

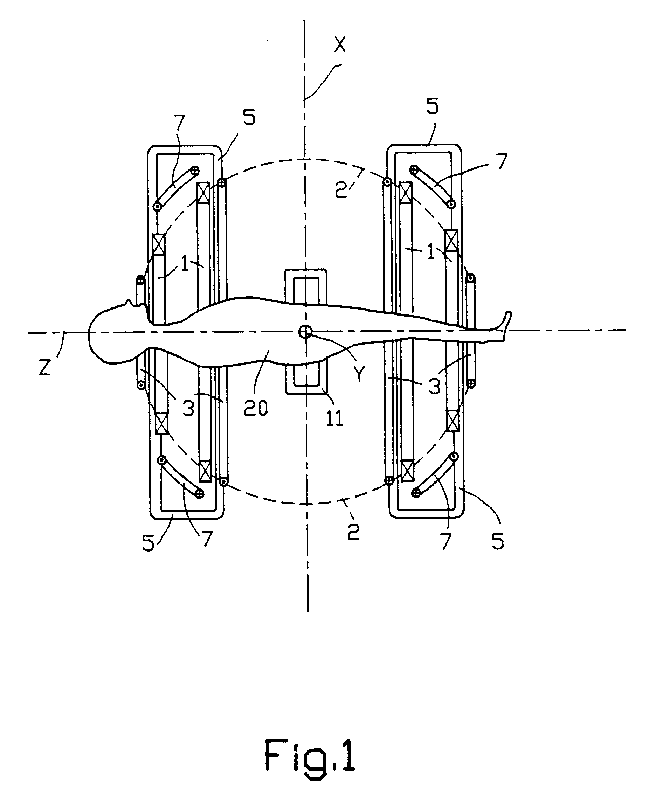

Das in Fig. 1 schematisch dargestellte Kernspinuntersuchungsgerät enthält eine aus vier Spulen 1 bestehende Anordnung zur Erzeugung eines homogenen stationären Magnetfeldes, das in der Größenordnung von einigen zehntel Tesla bis einigen Tesla liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy, Gx symmetrisch zur Kugeloberfläche 2 angeordnet ist, ist die Feldstärke im Kugelzentrum, das gleichzeitig den Koordinatenursprung des erwähnten kartesischen x-y-z-Koordinatensystems bildet, nur durch das stationäre homogene Magnetfeld der Spulenanordnung 1 bestimmt.

Weiterhin ist eine Hochfrequenzspule 11 symmetrisch zur Ebene z=0 des Koordinatensystems angeordnet, die so ausgebildet ist, daß damit ein im wesentlichen homogenes und in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter, im allgemeinen amplitudenmodulierter Strom von einem Hochfrequenzgenerator zugeführt. Im Anschluß an die drei Hochfrequenzimpulse jeder Teilsequenz dient die Hochfrequenzspule 11 zum Empfangen des im Untersuchungsbereich erzeugten Kernresonanzsignals. Stattdessen kann aber auch eine gesonderte Hochfrequenzempfangsspule verwendet werden.

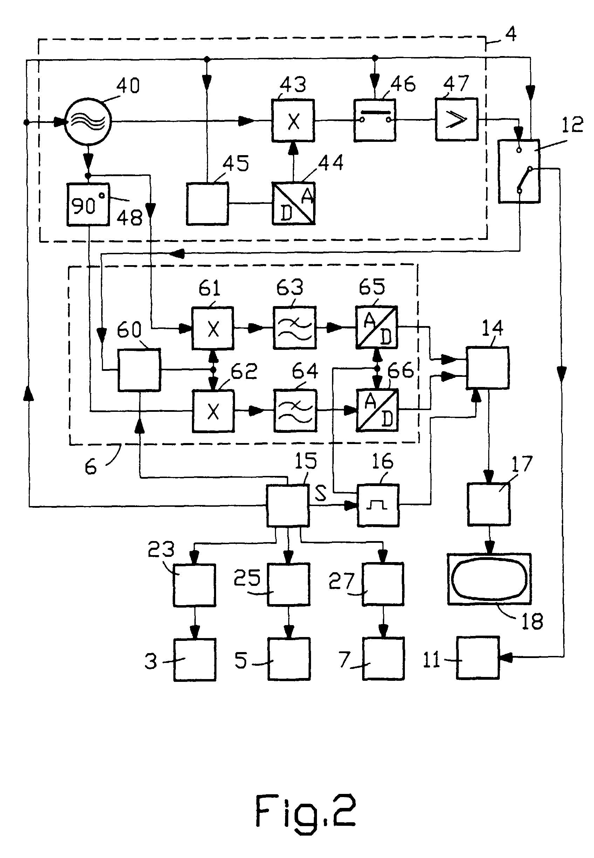

Fig. 2 zeigt ein vereinfachtes Blockschaltbild dieses Kernspinuntersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz von einer Steuereinheit 15 digital steuerbaren Hochfrequenzoszillator 40, der Schwingungen mit einer Frequenz im Bereich der Larmorfrequenz der anzuregenden Atomkerne bei der von den Spulen 1 erzeugten Feldstärke aufweist. Die Larmorfrequenz f berechnet sich bekanntlich nach der Beziehung f=cB, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch die Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenzleistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das jeweils in der Hochfrequenzspule 11 induzierte stimulierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils einen dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadraturdemodulator bildenden Schaltung 61..64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können. Die im Speicher 14 gespeicherten Datenworte bzw. Abtastwerte werden einem Rechner 17 zugeführt, der daraus durch eine diskrete Fouriertransformation die Spektralverteilung der Kernmagnetisierung ermittelt und die ermittelte Verteilung an einer geeigneten Wiedergabeeinheit, z.B. einem Monitor 18, ausgibt.

Die Gradientenspulenanordnungen 3, 5 und 7 werden von Stromgeneratoren 23, 25 und 27 jeweils mit einem Strom versorgt, dessen zeitlicher Verlauf durch die Steuereinheit 15 steuerbar ist.

Fig. 3 zeigt die Lage der für den klinischen Nachweis von Milchsäure wesentlichen Komponenten auf einer Frequenzskala, die die Abweichung von der Larmorfrequenz von TMS (Tetramethylsilan) angibt (in ppm). Die Larmorfrequenz von TMS liegt somit definitionsgemäß bei Null. Fig. 3 zeigt oberhalb des Nullpunkts zunächst eine Linie L₂, die von einer CH₃-Gruppe des Fettmoleküls herrührt. Diese Gruppe ist mit einer CH₂-Gruppe gekoppelt, die eine Frequenzlinie L₁ bei ca. 1,4 ppm aufweist. Diese skalare Kopplung ist durch die gestrichelten Linie zwischen L₁ und L₂ symbolisiert. Bei geeigneter Anregung weist die der Linie L₁ zugeordnete Molekülgruppe einen Doppelquantenübergang auf, während bei der Linie L₂ kein solcher Übergang erzeugt werden kann. Die Linie L₂ verschwindet also im Doppelquantenspektrum und ist daher in Fig. 3 nur gestrichelt angedeutet.

In unmittelbarer Nähe der Linie L₁ befindet sich eine Linie M₁ (bei ca. 1,33 ppm), die von der CH₃-Gruppe von Laktat herrührt. Diese CH₃-Gruppe ist skalar mit einer CH-Gruppe des Milchsäuremoleküls gekoppelt, deren Lamorfrequenz bei 4,1 ppm liegt. Beide Frequenzlinien erscheinen im Doppelquantenspektrum. Die Frequenzlinie W von an Wasser gebundenen Protonen liegt bei ca. 4,7 ppm. Diese Protonen können zwar an sich nicht in einen Doppelquantenzustand übergehen - weshalb die Frequenzlinie W ebenfalls gestrichelt dargestellt ist - doch läßt sich die Wasserkomponente, deren Intensität im biologischen Gewebe mehrere Zehnerpotenzen größer ist als die aller anderen Komponenten, nicht vollständig unterdrücken, und daher scheint diese Linie auch im Doppelquantenspektrum. Außerdem sind noch weitere Linien L₃ und L₄ dargestellt, die von Molekülgruppen des Fettmoleküls herrühren.

In biologischem Gewebe ist die Wasserkomponente W, auch wenn sie durch ein Verfahren der eingangs genannten Art um einen Faktor von z.B. 1000 unterdrückt worden ist, noch immer so intensiv, daß die in ihrer Nähe befindliche Milchsäurekomponente M₂ im Doppelquantenspektrum davon nicht getrennt werden kann. Die Milchsäurekomponente M befindet sich so dicht bei der Fettkomponente L₁, daß auch hier eine getrennte Messung nicht möglich ist, wenn im Untersuchungsbereich ein erheblicher Fettanteil enthalten ist, wie beispielsweise im Muskelgewebe. Eine unzweideutige Bestimmung des Milchsäuregehaltes aus einer Messung der Komponente M₁ ist daher nur möglich, wenn die ihr frequenzmäßig unmittelbar benachbarte Fettkomponente L₁ stark unterdrückt wird.

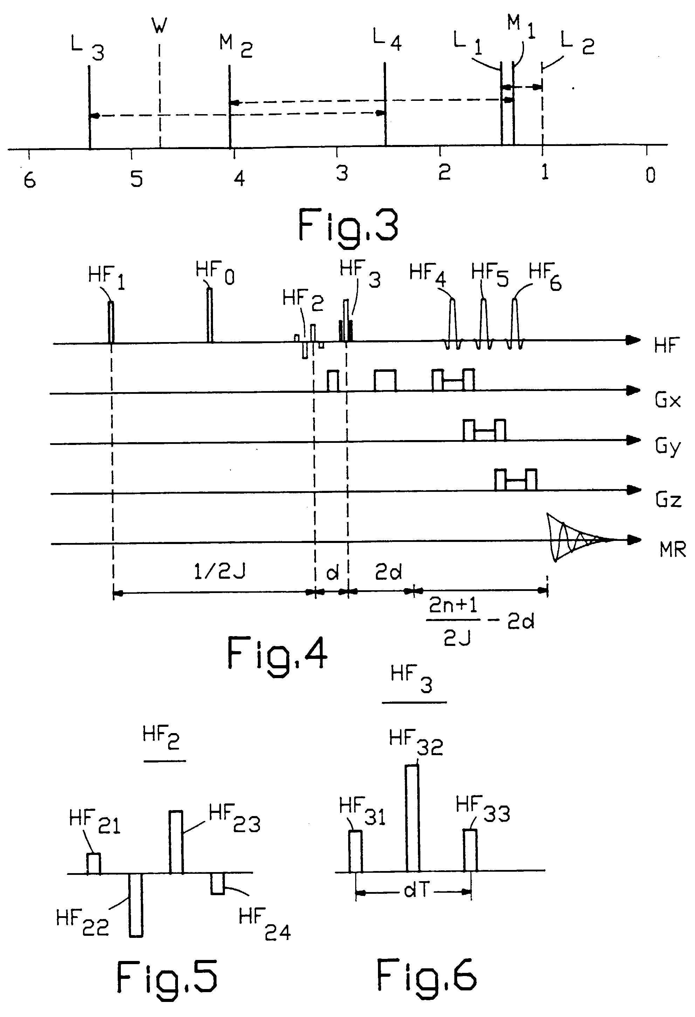

Diese Unterdrückung wird durch eine Sequenz erreicht, deren zeitlicher Verlauf in Fig. 4 dargestellt ist. Die erste Zeile von Fig. 4 zeigt die zeitliche Lage der von der Hochfrequenzspule 11 erzeugten magnetischen Hochfrequenzimpulse. Die zweite, dritte und vierte Zeile zeigt die zeitliche Lage der mittels der Gradientenspulen 7, 5 und 3 erzeugten magnetischen Gradientenfelder, deren Gradienten Gₓ, G_{y} bzw. G_{z} in x-, y- bzw. z-Richtung verlaufen. In der fünften Zeile ist das auftretende Kernresonanzsignal gezeichnet. Bei der Erfassung dieses Signales gibt die Steuereinheit 15 den Taktimpulsgenerator 16 frei, so daß die von der Hochfrequenzspule 11 gelieferten, in den Niederfrequenzbereich transponierten Kernresonanzsignale in eine Folge digitaler Datenworte umgesetzt und im Speicher 14 gespeichert werden können, wonach sie einer Fouriertransformation unterzogen werden.

Der erste Hochfrequenzimpuls HF₁ ist ein 90°-Impuls, der die in Fig. 3 dargestellten Frequenzkomponenten anregt. Der zweite Hochfrequenzimpuls HF₂ ist ebenfalls ein 90°-Impuls - zumindest für die bei 4,1 liegende Milchsäurekomponente M₂ - und wirkt auch auf die Komponenten W und L₃ sein zeitlicher Abstand vom Impuls HF₁ ist 1/2J, wobei J die skalare Kopplungskonstante von Milchsäure bzw. Fett ist, so daß sich ein zeitlicher Abstand von 68 ms ergibt. In der Mitte zwischen den Impulsen HF₁ und HF₂ befindet sich ein 180°-Hochfrequenzimpuls HF₀, der eine Refokussierung bewirkt und dadurch die Amplitude des Kernresonanzsignals vergrößert. Der Hochfrequenzimpuls HF₀ kann die gleiche Phasenlage haben wie HF₁; er kann jedoch auch gegenüber HF₁ um 90°, 180° oder 270° in der Phase versetzt sein.

Der zweite 90°-Hochfrequenzimpuls HF₂ ruft bei einem Teil der durch den ersten Hochfrequenzimpuls HF₁ angeregten Kernspins einen Doppel-Quantenübergang hervor. Der darauf folgende dritte Hochfrequenzimpuls HF₃ überführt u.a. diese Doppelquantenübergänge in einen Zustand, in dem sie ein meßbares Kernresonanzsignal liefern können. Zwischen dem zweiten und dem dritten Hochfrequenzimpuls und kurz nach dem dritten Hochfrequenzimpuls wird das magnetische Gradientenfeld Gx eingeschaltet, wobei das zeitliche Integral über dieses Gradientenfeld nach dem Impuls HF₃ dem Betrage nach gerade doppelt so groß ist wie das zeitliche Integral über dieses Feld zwischen dem Impuls HF₂ und dem Impuls HF₃. Die Vorzeichen der Gradientenfelder können gleich oder entgegengesetzt sein. In diesem Fall kompensiert sich die Wirkung des Gradientenfeldes Gₓ auf die Doppelquantenübergänge. Alle anderen Übergänge, beispielsweise auch der Einfach-Quantenübergang von Wasser, werden unterdrückt.

Zur Unterdrückung der Fettkomponente L₁, die der Milchsäurekomponente M₁ unmittelbar benachbart ist, gibt es verschiedene Möglichkeiten, die auch in Kombination miteinander angewandt werden können.
a) Der zweite Hochfrequenzimpuls wird derart frequenzselektiv gemacht, daß er zwar die Milchsäurekomponenten M₁, M₂ in einen Doppelquantenzustand überführt, aber nicht die Laktatkomponente L₁. Dies wird durch einen frequenzselektiven Hochfrequenzimpuls erreicht, der für eine Frequenz von 4,1 ppm (d.h. die Frequenz der mit M₁ gekoppelten Milchsäurekomponente M₂) als 90°-Hochfrequenzimpuls wirksam ist und der die Frequenz von 1 ppm, d.h. die Frequenz der mit L₁ gekoppelten Fettomponente L₂ nicht anregt. In der Regel bewirkt ein solcher frequenzselektiver Impuls für die zu L₂ benachbarten Komponenten L₁ und M₁ eine gewisse Anregung. Die Anregung von L₁ führt aber nicht dazu, daß ein Doppelquantenübergang auftritt, solange L₂ nicht angeregt wird. Die Anregung von M₁ unterstützt die Bildung von Doppelquantenübergängen, jedoch ist sie dafür nicht erforderlich; es würde genügen, wenn ausschließlich M₂ angeregt wird.
b) Wenn der dritte Hochfrequenzimpuls in gleicher Weise frequenzselektiv ist wie zuvor für den zweiten Hochfrequenzimpuls beschrieben, dann würden etwaige Doppelquantenübergänge der Fettkomponente L₁ nicht in einen Zustand überführt werden, indem sie ein Kernresonanzsignal erzeugen, bzw. einen Beitrag dazu liefern könnten. Noch günstiger ist aber die folgende Alternative: Der dritte Hochfrequenzimpuls M₂ wird derart gestaltet, daß er für die Frequenz der Komponente M₂ (4,1 ppm) als 90°-Impuls, für die Frequenz der Komponente M₁ (1,33 ppm) aber als 180°-Impuls wirksam ist. Es läßt sich zeigen, daß in diesem Fall eine zweite Komponente der Kernmagnetisierung von M₂ aus einem Doppelquantenzustand in einen einfachen Kohärenzzustand überführt wird, in dem sie ebenfalls einen Beitrag zu dem beobachtbaren Kernresonanz liefert. Dadurch wird die Amplitude des Signals bei M₂ verdoppelt. Da sich der Flip-Winkel des dritten Hochfrequenzimpulses um M₁ herum nicht abrupt ändern kann, wirkt der dritte Hochfrequenzimpuls auch für die zu M₁ frequenzmäßig benachbarten Fettkomponenten L₁ und L₂ nahezu als 180°-Impuls. Da somit die Fettkomponente L₂ keinen 90°-Impuls "sieht", sondern einen 180°-Impuls, bedeutet dies, daß etwaige Doppelquantenkohärenzzustände nicht in einen (beobachtbaren) Quantenkohärenzzustand überführt werden.

Die unter a) und b) angegebenen Möglichkeiten können einzeln angewandt werden; bevorzugt wird aber eine Kombination beider Möglichkeiten.

Der zur Unterdrückung der Fettkomponente gemäß a) erforderliche frequenzselektive Hochfrequenzimpuls HF₂ ist in Fig. 5 dargestellt. Dabei handelt es sich um einen sogenannten binomialen Hochfrequenzimpuls. Ein binomialer Hochfrequenzimpuls besteht bekanntlich aus einer Folge von Teilpulsen, deren zugeordnete Flip-Winkel (das ist der Winkel, um den die Kernmagnetisierung durch einen solchen Teilpuls aus der Ruhelage gekippt wird) im gleichen Verhältnis zueinander stehen wie die Binomialkoeffizienten. Der zeitliche Abstand zwischen zwei aufeinanderfolgenden Teilpulsen ist so gewählt, daß eine Schwingung, deren Frequenz der Differenz der anzuregenden und der zu unterdrückenden Frequenz entspricht, innerhalb dieses Zeitraums ihre Phase gerade um 180° oder ein ungeradzahliges Vielfaches davon geändert hat. Die Mittenfrequenz dieser Teilpulse fällt mit einer der beiden zuvor genannten Frequenzen zusammen.

Dementsprechend ist in Fig. 5 der Hochfrequenzimpuls HF₂ als 1,-3,3,-1-Hochfrequenzimpuls dargestellt, der aus den vier Teilpulsen HF₂₁..HF₂₄ besteht. Die Mittenfrequenz jedes dieser Hochfrequenzimpulse entspricht der Larmorfrequenz der Fettkomponente von L₂, liegt also bei ca. 1 ppm. Der erste Teilpuls HF₂₁ und der dritte Teilpuls HF₂₃ haben die selbe Phasenlage wie der erste 90°-Puls HF₁. Der zweite und der vierte Teilpuls HF₂₂ bzw. HF₂₄ haben die entgegengesetzte Phasenlage wie die vorgenannten Teilpulse. Der zeitliche Abstand zwischen jeweils zwei aufeinanderfolgenden Hochfrequenzimpulsen beträgt (2 df)⁻¹, wobei df die Differenzfrequenz zwischen M₂ und L₂ ist; bei einer magnetischen Flußdichte des homogenen stationären Magnetfeldes von 2T ergibt sich somit ein Abstand zwischen den Teilpulsen von rund 1,9 ms. Der erste und der letzte Teilpuls haben einen Flip-Winkel von jeweils 11,25°, während der Flipwinkel der Hochfrequenzimpulse HF₂₂ und HF₂₃ dreimal so groß ist. Für Kernspins, deren Larmorfrequenz der Mittenfrequenz der Teilpulse entspricht (wie z.B. für L₂) kompensieren sich die Wirkungen der Hochfrequenzimpulse HF₂₁ und HF₂₄ bzw. HF₂₂ und HF₂₃. Für die Komponente M₂ hingegen addiert sich die Wirkung der Impulse HF₂₁ .. HF₂₄, so daß die mit den einzelnen Teilpulsen verknüpften Flipwinkel sich für diese Komponente addieren und sich die Wirkung eines 90°-Hochfrequenzimpulses ergibt. Weil somit die mit der Komponente L₁ gekoppelte Komponente L₂ nicht angeregt wird, ruft der zweite Hochfrequenzimpuls bei der Komponente L₁ keinen Doppelquantenübergang hervor; diese L₁ wird also im Doppelquantenspektrum unterdrückt.

Die Teilpulse HF₂₂ und HF₂₄ können auch die gleiche Phasenlage haben wie die Teilpulse HF₂₁ und HF₂₃ bzw. wie der Hochfrequenzimpuls HF₁. In diesem Fall muß die Mittenfrequenz dieser Teilpulse mit der Frequenz der Komponente M₂ zusammenfallen.

In Fig. 6 ist eine Ausführungsform des Hochfrequenzimpulses HF₃ dargestellt, die die unter b angegebenen Bedingungen erfüllt. Der Hochfrequenzimpuls HF₃ umfaßt danach zwei identische 45°-Teilpulse HF₃₁ und HF₃₃, zwischen denen sich - in der Mitte - ein "harter" und somit breitbandiger 90°-Teilpuls HF₃₂ befindet. Für den zeitlichen Abstand dt zwischen den beiden Teilpulsen HF₃₁ und HF₃₃ gilt die Beziehung dt=n/2df. Dabei ist n eine ganze positive ungerade Zahl und df die Frequenzdifferenz zwischen den Larmorfrequenzen der Komponenten M₁ und M₂ (bei einem stationären Feld von 2T ca. 235 Hz). Wenn die Mittenfrequenz der Teilpulse HF₃₁ und HF₃₃ mit der Larmorfreuenz der Milchsäurekomponente M₁ zusammenfällt, müssen alle Teilpulse HF₃₁..HF₃₃ die gleiche Phasenlage haben wie die Hochfrequenzimpulse HF₁ und HF₀. Die Wirkungen der Teilpulse HF₃₁ und HF₃₃ kompensieren sich dann für die Milchsäurekomponente M₂ und sie addieren sich für die Milchsäurekomponente M₁, so daß letztere diese beiden Teilpulse als 90°-Impuls erfährt. Zusätzlich wirkt auf die genannten Komponenten - und alle übrigen Komponenten der Fig. 3 - der Teilpuls HF₃₂ ein. Somit wirkt der Hochfrequenzimpuls HF₃ für die Komponente M₂ als 90°-Impuls und für die Komponente M₁ als 180°-Impuls, was, wie unter b) erwähnt, zur Folge hat, daß die Amplitude des Doppelquantenüberganges M₁ im Kernresonanzsignal verdoppelt wird.

Es ist auch möglich, die Mittenfrequenz der Teilpulse HF₃₁ und HF₃₃ entsprechend der Frequenzkomponente M₂ zu wählen (4,1 ppm). In diesem Fall muß die Phase des Teilpulses HF₃₁ der Phase des Hochfrequenzimpulses HF₁ um 90° vorauseilen, während die Phase von HF₃₃ um 90° nacheilen muß; die Phase von HF₃₂ muß die gleiche sein wie die von HF₁.

Die Frequenzabhängigkeit des Flipwinkels von HF₃ zwischen M₂ und M₁ ändert sich cosinusförmig von 90° auf 180°. Infolgedessen ist der Flipwinkel für die Fettkomponenten L₁ und L₂, die frequenzmäßig relativ dicht bei M₁ liegen, nahezu 180°. Da somit die Komponente L₂ keinen 90°-Impuls "sieht", werden etwaige Doppelquantenübergänge bei der Fettkomponente L₁ allenfalls in vernachlässigbar kleinem Maße in einen Einfach-Quantenzustand überführt, indem sie beobachtbar werden.

Die durch den dritten Hochfrequenzimpuls HF₃ von einem Doppelquantenzustand in einen Einfachquantenzustand überführten Kernspinsysteme liefern ein Kernresonanzsignal, das seinen Maximalwert zu einer Zeit (2n+1)/(2J) nach dem dritten Hochfrequenzimpuls HF₃ erreicht, wobei n eine ganze Zahl ist, die größer als oder gleich Null ist. In diesem Zeitpunkt beginnt die Abtastung des in der fünften Zeile von Fig. 4 dargestellten Kernresonanzsignals, d.h. die Steuereinheit 15 gibt dann den Taktimpulsgenerator 16 frei, so daß die Analogsignale digitalisiert und gespeichert werden, wonach sie einer Fouriertransformation unterzogen werden, aus der sich das Doppelquantenspektrum ergibt. In diesem Spektrum ist die Wasserlinie um einen Faktor von wenigstens 1000 kleiner, und die Intensität der Fettkomponente L₁ wird um einen Faktor von rund 500 reduziert. Bei der Durchführung der Teilsequenzen soll der zeitliche Abstand zwischen den Hochfrequenzimpulsen HF₂ und HF₃ möglichst klein ist, aber immer noch genügend groß, um dazwischen ein magnetischen Gradientenfeld ein- und auszuschalten, mit dessen Hilfe die unerwünschten Spektralkomponenten unterdrückt werden.

Bei klinischen Anwendungen geht es meist nicht darum, den Milchsäuregehalt in dem gesamten Untersuchungsbereich zu bestimmen, sondern nur in einem umgrenzten Teil, der beispielsweise ein menschliches Organ oder ein Teil davon sein kann. Es ist daher erforderlich, das Volumen zu selektieren, das spektroskopisch untersucht werden soll. Zu diesem Zweck sind Anregungsverfahren bekannt, bei denen die zur Selektion erforderlichen Impulse vor oder während der spektroskopischen Untersuchung erzeugt werden. Dadurch wird aber das spektroskopische Experiment negativ beeinflußt.

Bei der Erfindung erfolgt die Selektion nach dem dritten Hochfrequenzimpuls mit Hilfe dreier schichtselektiver 180°-Hochfrequenzimpulse HF₄, HF₅ und HF₆, die jeweils von einem der drei magnetischen Gradientenfelder Gx, Gy und Gz begleitet werden, wie in Fig. 4 dargestellt. Dadurch wird ein Volumen selektiert, dessen Abmessungen von der Bandbreite der Hochfrequenzimpulse HF₄..HF₆ sowie von der Stärke des magnetischen Gradientenfeldes während dieser Impulse abhängen. Diese für die Selektion erforderliche Teilsequenz mit den 180°-Impulsen HF₄..HF₆ ist nach dem Hochfreuenzimpuls HF₃ wirksam, und bevor das Kernresonanzsignal sein Maximum erreicht. Der zeitliche Abstand dieser Teilsequenz zu dem Impuls HF₃ muß mindestens 2d betragen, wobei d der Abstand zwischen den Hochfrequenzimpulsen HF₂ und HF₃ ist. Die Teilsequenz soll in der Mitte des zur Zeit 2d beginnenden und zur Zeit (2n+1)/(2J) nach dem dritten Hofrequenzimpuls endenden Zeitraums liegen. Die drei schichtselektiven Hochfrequenzimpuls HF₄.. HF₆ wirken in bezug auf das selektierte Volumenelement wie ein einziger 180°-Impuls, dessen zeitliche Lage bei gleichem Abstand zwischen den Hochfrequenzimpulsen derjenigen des zweiten 180°-Hochfrequenzimpulses (HF₅) entspricht und der die Kernmagnetisierung in dem Volumenelement wieder refokussiert, ohne im übrigen die Spin-Spin-Wechselwirkungen und die Quantenkohärenzen zu beeinflussen.

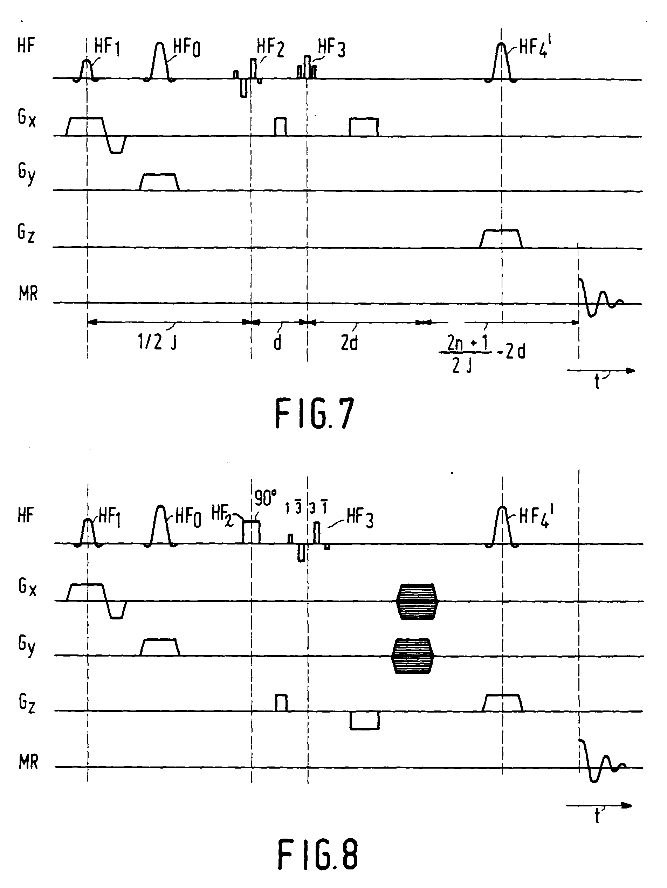

Fig. 7 zeigt eine alternative volumenselektive Sequenz. Sie entspricht im wesentlichen derjenigen nach Figur 4, jedoch wird statt der drei Hochfrequenzimpulse HF₄.., HF₆ nur ein einziger von einem magnetischen Gradientenfeld (Gz) begleiteter Hochfrequenzimpuls HF₄′ erzeugt, und zusätzlich werden auch die Hochfrequenzimpulse HF₁ und HF₀ durch ein sie begleitendes magnetisches Gradientenfeld schichtselektiv gemacht. Die Gradienten der die drei Hochfrequenzimpulse HF₁, HF₀ und HF₄′ begleitenden magnetischen Gradientenfelder stehen zueinander senkrecht.

In Fig. 8 ist eine modifizierte Sequenz dargestellt, die ein Laktatimaging gestattet, d.h. die Ermittlung der räumlichen Verteilung von Laktat in einer Schicht des Untersuchungsbereichs. Jede Sequenz umfaßt dabei die vier Hochfrequenzimpulse HF₁, HF₀, HF₂ und HF₃, die bei Wiederholungen der Sequenz jeweils den gleichen zeitlichen Verlauf haben. Dieser Verlauf kann demjenigen nach Fig. 4 entsprechen, jedoch kann auch einer der beiden Hochfrequenzimpulse HF₂ oder HF₃ nicht frequenzselektiv sein. Diesen Impulsen folgt ein weiterer Hochfrequenzimpuls HF₄′, der als 180°-Impuls ausgebildet ist. Seine zeitliche Lage entspricht z.B. derjenigen des Hochfrequenzimpulses HF₅ bei der Sequenz nach Fig. 4. Wiederum werden Einfachquantenkohärenzen dadurch unterdrückt, daß zwischen HF₂ und HF₃ ein magnetisches Gradientenfeld Gz ein- und ausgeschaltet und daß das gleiche magnetische Gradientenfeld nach HF₃ wiederum ein- und ausgeschaltet wird, wobei der Betrag des zeitlichen Integrals über dieses Gradientenfeld nach HF₃ doppelt so groß ist wie zwischen HF₂ und HF₃.

Zwischen HF₃ und HF₄′ werden zwecks Phasencodierung magnetische Gradientenfelder (Gₓ, Gy) eingeschaltet, wobei das zeitliche Integral über jedes dieser Gradientenfelder bei Wiederholungen der Sequenz variiert wird, z.B. in jeweils 128 Schritten, so daß insgesamt 128 x 128 Wiederholungen erforderlich sind. Das durch den Impuls HF₄′ refokussierte Kernresonanzsignal wird digitalisiert, gespeichert und einer zweidimensionalen Fouriertransformation unterzogen, aus der sich ein Bild der Laktatverteilung in der durch den Hochfrequenzimpuls HF₄ in Verbindung mit dem ihn begleitenden Gradientenfeld bestimmten Schicht ergibt.

## Patentansprüche

1. Kernspinresonanz-Spektroskopieverfahren zum Editieren der von der CH-Gruppe und der CH₃-Gruppe von Laktat herrührenden Laktatkomponenten, in Gegenwart von Fettmolekülen mit einer störenden, von der CH₂-Gruppe herrührenden Lipidkomponente (L₁), bei dem in Anwesenheit eines homogenen stationären Magnetfeldes auf einen Untersuchungsbereich eine Vielzahl von Sequenzen einwirkt, von denen jede wenigstens drei Hochfrequenzimpulse (HF₁, HF₂, HF₃) umfaßt, wobei der Abstand der beiden ersten Hochfrequenzimpulse (HF₁, HF₂) gleich dem Kehrwert des Zweifachen der skalaren Kopplungskonstante J der miteinander gekoppelten Laktatkomponenten ist und wobei zwischen bzw. nach den Impulsen magnetische Gradientenfelder (Gₓ) mit solcher Amplitude und Dauer wirksam werden, daß nach dem dritten Hochfrequenzimpuls auftretende Kernspinresonanzsignale nur durch Doppelquantenkohärenz bestimmt sind,
dadurch gekennzeichnet, daß der zweite und/oder der dritte Hochfrequenzimpuls (HF₂, HF₃) derart frequenzselektiv ist, daß er für die von der CH-Gruppe herrührende Laktatkomponente (M₂) als 90°-Hochfrequenzimpuls und für die jenige Lipidkomponente (L₂) als 0°-Hochfrequenzimpuls wirksam ist, die von der CH₃-Gruppe des Fettmoleküls herrührt und die mit der von der CH₂-Gruppe herrührenden Lipidkomponente (L₁) gekoppelt ist.

2. Kernspinresonanz-Spektroskopieverfahren zum Editieren der von der CH-Gruppe und der CH₃-Gruppe von Laktat herrührenden Laktatkomponenten in Gegenwart von Fettmolekülen mit einer störenden, von der CH₂-Gruppe herrührenden Lipidkomponente (L₁), bei dem in Anwesenheit eines homogenen stationären Magnetfeldes auf einen Untersuchungsbereich eine Vielzahl von Sequenzen einwirkt, von denen jede wenigstens drei Hochfrequenzimpulse (HF₁, HF₂, HF₃) umfaßt, wobei der Abstand der beiden ersten Hochfrequenzimpulse (HF₁, HF₂) gleich dem Kehrwert des Zweifachen der skalaren Kopplungskonstante J der miteinander gekoppelten Laktatkomponenten ist und wobei zwischen bzw. nach den Impulsen magnetische Gradientenfelder (Gₓ) mit solcher Amplitude und Dauer wirksam werden, daß nach dem dritten Hochfrequenzimpuls auftretende Kernspinresonanzsignale nur durch Doppelquantenkohärenz bestimmt sind,
dadurch gekennzeichnet, daß der dritte Hochfrequenzimpuls (HF₃) derart frequenzselektiv ist, daß er für die von der CH-Gruppe herrührende Laktatkomponente (M₂) als 90°-Impuls wirksam ist und für die von der CH₃-Gruppe herrührende Laktatkomponente (M₁) als 180°-Impuls.

3. Kernspinresonanz-Spektroskopieverfahren nach Anspruch 1 oder Anspruch 2,
dadurch gekennzeichnet, daß die nicht frequenzselektiven Hochfrequenzimpulse (HF₁) 90°-Impulse sind.

4. Verfahren nach einem der Ansprüche 1 bis 3,
dadurch gekennzeichnet, daß - vorzugsweise in der Mitte - zwischen dem ersten und dem zweiten Hochfrequenzimpuls (HF₁, HF₂) ein 180°-Impuls (HF₀) erzeugt wird.

5. Verfahren nach einem der Ansprüche 1 bis 4,
dadurch gekennzeichnet, daß der zweite Hochfrequenzimpuls (HF₂) ein binomialer Hochfrequenzimpuls ist, der. bei 4,1 ppm als 90°-Impuls wirksam und bei 1 ppm unwirksam ist.

6. Verfahren nach einem der Ansprüche 1 bis 5,
dadurch gekennzeichnet, daß der dritte Hochfrequenzimpuls (HF₃) aus drei Teilimpulsen besteht, von denen der zweite Impuls ein breitbandiger 90°-Impuls (HF₃₂) und der erste und der dritte binomiale 45°-Impulse (HF₃₁, HF₃₃) sind, die bei 4,1 ppm unwirksam und bei 1,33 ppm als 90°-Impuls wirksam sind.

7. Verfahren nach einem der Ansprüche 4 bis 6,
dadurch gekennzeichnet, daß zur Volumenselektion der erste Hochfrequenzimpuls (HF₁), der danach vor dem zweiten Impuls erzeugte Hochfrequenzimpuls (HF₀) und ein vierter - vorzugsweise als 180°-Hochfrequenzimpuls ausgebildeter - auf den dritten Impuls folgender Hochfrequenzimpuls (HF₄') von magnetischen Gradientenfeldern (Gx, Gy, Gz) begleitet werden, deren Gradienten senkrecht zueinander verlaufen.

8. Verfahren nach einem der Ansprüche 1 bis 6,
dadurch gekennzeichnet, daß zur Bestimmung der räumlichen Laktatverteilung nach dem dritten Hochfrequenzimpuls (HF₃) ein vierter - vorzugsweise als 180°-Impuls ausgebildeter - von einem magnetischen Gradientenfeld (Gz) begleiteter Hochfrequenzimpuls (HF₄') erzeugt wird, daß zwischen dem dritten und dem vierten Hochfrequenzimpuls zwei Gradienten zueinander sowie zu dem während des vierten Hochfrequenzimpulses (HF₄') wirksamen Gradienten senkrecht verlaufen und daß bei der Wiederholung der Sequenz das zeitliche Integral des Gradienten wenigstens eines der beiden zwischen dem dritten und dem vierten Hochfrequenzimpuls wirksamen Gradientenfelder variiert ist.

9. Verfahren nach einem der Ansprüche 1 bis 6,
dadurch gekennzeichnet, daß zur Volumenselektion jede Teilsequenz im Anschluß an die drei Hochfrequenzimpulse (HF₁...HF₃) drei weitere, als 180°-Impulse wirksame Hochfrequenzimpulse (HF₄...HF₆) umfaßt, die mit je einem magnetischen Gradientenfeld (Gx, Gy, Gz) verknüpft sind, wobei die Gradienten der bei den drei 180°-Impulsen wirksamen Gradientenfelder senkrecht zueinander verlaufen.

10. Kernspinresonanz-Anordnung mit
- einem Magneten (1) zur Erzeugung eines homogenen stationären Magnetfeldes,
- einer Hochfrequenzspulenanordnung (11) zur Erzeugung von Hochfrequenzsignalen und zum Empfangen von Kernspinresonanzsignalen,
- einem Hochfrequenzsender (4) zum Erzeugen von Hochfrequenzimpulsen (HF₁...HF₃),
- einer Gradientenspulenanordnung (3,5,7) zur Erzeugung magnetischer Gradientenfelder,
- einem Hochfrequenzempfänger (6) zum Empfang von Kernspinresonanzsignalen,
- Mitteln (17) zum Bestimmen des Spektrums der Kernspinresonanzsignale und - einer Steuereinheit (15), die den Hochfrequenzsender und die Ströme in der Gradientenspulenanordnung derart steuert, daß eine Vielzahl von Sequenzen auf den Untersuchungsbereich einwirkt, von denen jede wenigstens drei Hochfrequenzimpulse umfaßt, wobei der Abstand der beiden ersten Hochfrequenzimpulse (HF₁, HF₂) gleich dem Kehrwert des Zweifachen der skalaren Kopplungskonstante J der miteinander gekoppelten Laktatkomponenten ist und wobei zwischen bzw. nach den Hochfrequenzimpulsen magnetische Gradientenfelder (Gₓ) mit solcher Amplitude und Dauer wirksam werden, daß nach dem dritten Hochfrequenzimpuls auftretende Kernspinresonanzsignale nur durch Doppelquantenkohärenz bestimmt sind,
dadurch gekennzeichnet, daß die Steuereinheit zur Durchführung des Verfahrens nach Anspruch 1 so programmiert ist, daß der zweite und/oder der dritte Hochfrequenzimpuls (HF₂, HF₃) derart frequenzselektiv ist, daß er für die von der CH-Gruppe herrührende Laktatkomponente (M₂) als 90°-Hochfrequenzimpuls und für die jenige Lipidkomponente (L₂) als 0°-Hochfrequenzimpuls wirksam ist, die von der CH₃-Gruppe des Fettmoleküls herrührt und die mit der von der CH₂-Gruppe herrührenden Lipidkomponente (L₁) gekoppelt ist.

11. Kernspinresonanz-Anordnung mit
- einem Magneten (1) zur Erzeugung eines homogenen stationären Magnetfeldes,
- einer Hochfrequenzspulenanordnung (11) zur Erzeugung von Hochfrequenzsignalen und zum Empfangen von Kernspinresonanzsignalen,
- einem Hochfrequenzsender (4) zum Erzeugen von Hochfrequenzimpulsen (HF₁...HF₃),
- einer Gradientenspulenanordnung (3,5,7) zur Erzeugung magnetischer Gradientenfelder,
- einem Hochfrequenzempfänger (6) zum Empfang von Kernspinresonanzsignalen,
- Mitteln (17) zum Bestimmen des Spektrums der Kernspinresonanzsignale und
- einer Steuereinheit (15), die den Hochfrequenzsender und die Ströme in der Gradientenspulenanordnung derart steuert, daß eine Vielzahl von Sequenzen auf den Untersuchungsbereich einwirkt, von denen jede wenigstens drei Hochfrequenzimpulse umfaßt, wobei der Abstand der beiden ersten Hochfrequenzimpulse (HF₁, HF₂) gleich dem Kehrwert des Zweifachen der skalaren Kopplungskonstante J der miteinander gekoppelten Laktatkomponenten ist und wobei zwischen bzw. nach den Hochfrequenzimpulsen magnetische Gradientenfelder (Gₓ) mit solcher Amplitude und Dauer wirksam werden, daß nach dem dritten Hochfrequenzimpuls auftretende Kernspinresonanzsignale nur durch Doppelquantenkohärenz bestimmt sind,
dadurch gekennzeichnet, daß die Steuereinheit zur Durchführung des Verfahrens nach Anspruch 2 so programmiert ist, daß der dritte Hochfrequenzimpuls (HF₃) derart frequenzselektiv ist, daß er für die von der CH-Gruppe herrührende Laktatkomponente (M₂) als 90°-Impuls wirksam ist und für die von der CH₃-Gruppe herrührende Laktatkomponente (M₁) als 180°-Impuls.

## Claims

1. A magnetic resonance spectroscopy method for editing the lactate components stemming from the CH group and the CH₃ group of lactated in the presence of fat molecules with a disturbing lipid component (L₁) stemming from the CH₂ group, where a plurality of sequences act on an examination zone in the presence of a uniform, steady magnetic field, each sequence comprising at least three RF pulses (HF₁, HF₂, HF₃), the distance between the first two RF pulses (HF₁, HF₂) being equal to the reciprocal value of twice the scalar coupling constant J of the coupled lactate components, between and after the pulses there being applied magnetic gradient fields (Gₓ) having an amplitude and a duration such that spin resonance signals occurring after the third RF pulse are determined exclusively by double quantum coherence, characterized in that the second and/or the third RF pulse (HF₂, HF₃) is frequency-selective in such a manner that it acts as a 90° RF pulse for the lactate component (M₂) stemming from the CH group and as a 0° RF pulse for that lipid component (L₂) that stems from the CH₃ group of the fat molecule and is coupled to the lipid component (L₁) stemming from the CH₂ group.

2. A magnetic resonance spectroscopy method for editing the lactate components stemming from the CH group and the CH₃ group of lactate in the presence of fat molecules with a disturbing lipid component (L₁) stemming from the CH₂ group, where a plurality of sequences act on an examination zone in the presence of a uniform, steady magnetic field, each sequence comprising at least three RF pulses (HF₁, HF₂, HF₃), the distance between the first two RF pulses (HF₁, HF₂) being equal to the reciprocal value of twice the scalar coupling constant J of the coupled lactate components, between and after the pulses there being applied magnetic gradient fields (Gₓ) having and amplitude and duration such that spin resonance signals occurring after the third RF pulse are determined exclusively by double quantum coherence, characterized in that the third RF pulse (HF₃) is frequency-selective in such manner that it acts as a 90° pulse for the lactate component (M₂) stemming from the CH group and as a 180° pulse for the lactate component (M₁) stemming from the CH₃ group.

3. A magnetic resonance spectroscopy method as claimed in Claim 1 or Claim 2, characterized in that the RF pulses (HF₁) which are not frequency selective are 90° pulses.

4. A method as claimed in any one of the Claims 1 to 3, characterized in that a 180° pulse (HF₀) is generated preferably halfway between the first and the second RF pulse (HF₁, HF₂).

5. A method as claimed in any one of the Claims 1 to 4, characterized in that the second RF pulse (HF₂) is a binomial RF pulse which acts as a 90° pulse at 4.1 ppm and is ineffective at 1 ppm.

6. A method as claimed in any one of the Claims 1 to 5, characterized in that the third RF pulse (HF₃) consists of three sub-pulses, the second of which is a broadband 90° pulse (HF₃₂), the first and the third sub-pulse being binomial 45° pulses (HF₃₁, HF₃₃) which are ineffective at 4.1 ppm and act as a 90° pulse at 1.33 ppm.

7. A method as claimed in any one of the Claims 4 to 6, characterized in that for volume selection the first RF pulse (HF₁), the subsequent RF pulse (HF₀), generated before the second pulse, and a fourth RF pulse (HF₄'), preferably conceived as a 180° RF pulse and succeeding the third pulse, are accompanied by magnetic gradient fields (Gx, Gy, Gz) whose gradients extend perpendicularly to one another.

8. A method as claimed in any one of the Claims 1 to 6, characterized in that for the determination of the spatial lactate distribution, after the third RF pulse (HF₃) there is generated a fourth RF pulse (HF₄') which is preferably conceived as a 180° pulse and which is accompanied by a magnetic gradient field (Gz), that between the third and the fourth RF pulse two gradients extend perpendicularly to one another and to the gradient applied during the fourth RF pulse (HF₄'), and that upon repetition of the sequence the time integral of the gradient of at least one of the two gradient fields applied between the third and the fourth RF pulse is varied.

9. A method as claimed in any one of the Claims 1 to 6, characterized in that for volume selection each sub-sequence comprises, subsequent to the three RF pulses (HF₁ ... HF₃), three further RF pulses (HF₄ ... HF₆) which act as 180° pulses and which are accompanied by a respective magnetic gradient field (Gx, Gy, Gz), the gradients of the gradient fields applied for the three 180° pulses extending perpendicularly to one another.

10. A magnetic resonance apparatus, including
- a magnet (1) for generating a uniform, steady magnetic field,
- an RF coil system (11) for generating RF signals and for receiving spin resonance signals,
- an RF transmitter (4) for generating RF pulses (HF₁...H₃),
- a gradient coil system (3, 5, 7) for generating magnetic gradient fields,
- an RF receiver (6) for receiving spin resonance signals,
- means (17) for determining the spectrum of the spin resonance signals, and
- a control unit (15) which controls the RF transmitter and the currents in the gradient coil system in such a manner that a plurality of sequences act on the examination zone, each sequence comprising at least three RF pulses, the distance between the first two RF pulses (HF₁, HF₂) being equal to the reciprocal value of twice the scalar coupling constant J of the coupled lactate components, between and after the RF pulses there being applied magnetic gradient fields (Gₓ) having an amplitude and a duration such that spin resonance signals occurring after the third RF pulse are determined exclusively by double quantum coherence, characterized in that the control unit for carrying out the method claimed in Claim 1 is programmed so that the second and/or the third RF pulse (HF₁, HF₂) is frequency-selective in such a manner that it is acts as a 90° RF pulse for the lactate component (M₂) stemming from the CH group and as a 0° RF pulse for that lipid component (L₂) that stems from the CH₃ group of the fate molecule and is coupled to the lipid component (L₁) stemming from the CH₂ group.

11. A magnetic resonance apparatus, including
- a magnet (1) for generating a uniform, steady magnetic field,
- an RF coil system (11) for generating RF signals and for receiving spin resonance signals,
- an RF transmitter (4) for generating RF pulses (HF₁...H₃),
- a gradient coil system (3, 5, 7) for generating magnetic gradient field,
- an RF receiver (6) for the receiving spin resonance signals,
- means (17) for determining the spectrum of the spin resonance signals, and
- a control unit (15) which controls the RF transmitter and the currents in the gradient coil system in such a manner that a plurality of sequences act on the examination zone, each sequence comprising at least three RF pulses, the distance between the first two RF pulses (HF₁, HF₂) being equal to the reciprocal value of twice the scalar coupling constant J of the coupled lactate components, between and after the RF pulses there being applied magnetic gradient fields (Gₓ) having an amplitude and a duration such that spin resonance signals occurring after the third RF pulse are determined exclusively by double quantum coherence, characterized in that the control unit for carrying out the method claimed in Claim 2 is programmed so that the third RF pulse (HF₃) is frequency-selective in such a manner that it act as a 90° for the lactate component (M₂) stemming from the CH group and as a 180° pulse for the lactate component (M₁) stemming from the CH₃ group.

## Revendications

1. Procédé de spectroscopie à résonance magnétique nucléaire pour l'édition des composantes de lactate provenant du radical CH et du radical CH₃ du lactate en présence de molécules de graisse avec une composante perturbatrice de lipide (L₁) provenant du radical CH₂, plusieurs séquences dont chacune comprend au moins trois impulsions à haute fréquence (HF₁, HF₂, HF₃), agissant sur une région à examiner en présence d'un champ magnétique stationnaire homogène, où l'écart entre les deux premières impulsions à haute fréquence (HF₁, HF₂) est égal à la valeur inverse du double de la constante de liaison scalaire J des composantes de lactate reliées l'une à l'autre et où des champs à gradients magnétiques (Gx) agissant entre ou après les impulsions avec une amplitude et une durée telles que les signaux à résonance magnétique nucléaire apparaissant après la troisième impulsion à haute fréquence ne sont déterminés que par une cohérence à double quantum,
caractérisé en ce que les deuxième et/ou troisième impulsions à haute fréquence (HF₂, HF₃) sont sélectives sur le plan de la fréquence de telle sorte qu'elles agissent comme une impulsion à haute fréquence à 90° pour la composante de lactate (M₂) provenant du radical CH ou comme une impulsion à haute fréquence à 0°, pour la composante de lipide (L₂) qui provient du radical CH₃ de la molécule de graisse et qui est reliée à la composante de lipide (L₁) provenant du radical CH₂.

2. Procédé de spectroscopie à résonance magnétique nucléaire pour l'édition des composantes de lactate provenant du radical CH et du radical CH₃ du lactate en présence de molécules de graisse avec une composante perturbatrice de lipide (L₁) provenant du radical CH₂, plusieurs séquences dont chacune comprend au moins trois impulsions à haute fréquence (HF₁, HF₂, HF₃), agissant sur une région à examiner en présence d'un champ magnétique stationnaire homogène, où l'écart entre les deux premières impulsions à haute fréquence (HF₁, HF₂) est égal à la valeur inverse du double de la constante de liaison scalaire J des composantes de lactate reliées l'une à l'autre et où des champs à gradients magnétiques (Gx) agissant entre ou après les impulsions avec une amplitude et une durée telles que les signaux à résonance magnétique nucléaire apparaissant après la troisième impulsion à haute fréquence ne sont déterminés que par une cohérence à double quantum,
caractérisé en ce qu'en vue de la réduction de la composante de lipide (L₁) dans la région de la composante de lactate (M₁) des deuxième et/ou troisième impulsions à haute fréquence (HF₂, HF₃) sont sélectives sur le plan de la fréquence de telle sorte qu'elles agissent comme une impulsion à 90° pour la composante (M₂) liée à la composante de lactate (M₁) et comme une impulsion à 0° ou 180° pour la composante (L₂) liée à la composante de lipide (L₁).

3. Procédé de spectroscopie à résonance magnétique nucléaire selon la revendication 1 ou la revendication 2,
caractérisé en ce que les impulsions à haute fréquence (HF₁) non sélectives sur le plan de la fréquence sont des impulsions à 90°.

4. Procédé selon l'une des revendications 1 à 3,
caractérisé en ce que - de préférence au centre - une impulsion à 180° (HF₀) est produite entre les première et deuxième impulsions à haute fréquence (HF₁, HF₂).

5. Procédé selon l'une des revendications 1 à 4,
caractérisé en ce que la deuxième impulsion à haute fréquence (HF₂) est une impulsion à haute fréquence binomiale qui est active à 4,1 ppm comme impulsion à 90° et inactive à 1 ppm.

6. Procédé selon l'une des revendications 1 à 5,
caractérisé en ce que la troisième impulsion à haute fréquence (HF₃) se compose de trois impulsions partielles dont la deuxième impulsion est une impulsion à 90° à large bande (HF₃₂) et les première et troisième impulsions binomiales sont des impulsions à 45° (HF₃₁, HF₃₃) qui sont inactives à 4,1 ppm et actives à 1,33 ppm comme impulsion à 90°.

7. Procédé selon l'une des revendications 4 à 6,
caractérisé en ce que, pour la sélection du volume, la première impulsion à haute fréquence (HF₁), l'impulsion à haute fréquence produite ensuite avant la deuxième impulsion (HF₀) et une quatrième impulsion à haute fréquence (HF₄') suivant la troisième impulsion et conçue de préférence comme une impulsion à haute fréquence à 180° sont accompagnées par des champs à gradients magnétiques (Gx, Gy, Gz) dont les gradients s'étendent perpendiculairement l'un à l'autre.

8. Procédé selon l'une des revendications 1 à 6,
caractérisé en ce que, pour la détermination de la distribution spatiale du lactate après la troisième impulsion à haute fréquence (HF₃), il est produit une quatrième impulsion à haute fréquence (HF₄') accompagnée par un champ à gradient magnétique (Gz) - conçue de préférence comme une impulsion à 180° -, qu'entre les troisième et quatrième impulsions à haute fréquence s'étendent deux gradients perpendiculaires l'un à l'autre ainsi que par rapport au gradient agissant pendant la quatrième impulsion à haute fréquence (HF₄') et qu'en cas de répétition de la séquence, l'intégrale temporelle du gradient d'au moins un des deux champs à gradients agissant entre les troisième et quatrième impulsions à haut fréquence varie.

9. Procédé selon l'une des revendications 1 à 6,
caractérisé en ce que, pour la sélection du volume, chaque séquence partielle comprend à la suite des trois impulsions à haute fréquence (HF₁...HF₃) trois autres impulsions à haute fréquence (HF₄...HF₆) agissant comme des impulsions à 180° qui sont reliées respectivement à un champ à gradient magnétique (Gx, Gy, Gz), où les gradients des champs à gradients agissant pour les trois impulsions à 180° s'étendent perpendiculairement l'un à l'autre.

10. Dispositif de résonance magnétique nucléaire pour la réalisation du procédé selon la revendication 1, avec :
- un aimant (1) pour la production d'un champ magnétique stationnaire homogène,
- un agencement de bobines à haute fréquence (11) pour la production de signaux à haute fréquence et la réception de signaux de résonance magnétique nucléaire,
- un émetteur de haute fréquence (4) pour la production d'impulsions à haute fréquence (HF₁...HF₃),
- un agencement de bobines à gradients (3, 5, 7) pour la production de champs à gradients magnétiques,
- un récepteur à haute fréquence (6) pour la réception de signaux de résonance magnétique nucléaire,
- des moyens (17) pour déterminer le spectre des signaux de résonance magnétique nucléaire, et
- une unité de commande (15) qui commande l'émetteur à haute fréquence et les courants dans l'agencement de bobines à gradients de telle sorte que plusieurs séquences agissent sur la région à examiner, dont chacune comprend au moins trois impulsions à haute fréquence, où l'écart entre les deux premières impulsions à haute fréquence (HF₁, HF₂) est égal à la valeur inverse du double de la constante de liaison scalaire J des composantes de lactate reliées l'une à l'autre et où, entre ou après les impulsions à haute fréquence, des champs à gradients magnétiques (Gx) agissant avec une amplitude et une durée telles que les signaux de résonance magnétique nucléaire agissant après la troisième impulsion à haute fréquence ne sont déterminés que par cohérence à double quantum,
caractérisé en ce que l'unité de commande pour la réalisation du procédé suivant la revendication 1 est programmée de telle sorte que les deuxième et/ou troisième impulsions à haute fréquence (HF₂, HF₃) soient sélectives sur le plan de la fréquence de telle sorte qu'elles agissent comme une impulsion à haute fréquence à 90° pour la composante de lactate (M₂) provenant du radical CH et comme une impulsion à haute fréquence à 0° pour la composante de lipide (L₂) qui provient du radical CH₃ de la molécule de graisse et est reliée à la composante de lipide (L₁) provenant du radical CH₂.

11. Dispositif de résonance magnétique nucléaire pour la réalisation du procédé selon la revendication 2, avec :
- un aimant (1) pour la production d'un champ magnétique stationnaire homogène,
- un agencement de bobines à haute fréquence (11) pour la production de signaux à haute fréquence et la réception de signaux de résonance magnétique nucléaire,
- un émetteur à haute fréquence (4) pour la production d'impulsions à haute fréquence (HF₁...HF₃),
- un agencement de bobines à gradients (3, 5, 7) pour la production de champs à gradients magnétiques,
- un récepteur à haute fréquence (6) pour la réception de signaux de résonance magnétique nucléaire,
- des moyens (17) pour déterminer le spectre des signaux de résonance magnétique nucléaire, et
- une unité de commande (15) qui commande l'émetteur à haute fréquence et les courants dans l'agencement de bobines à gradients de telle sorte que plusieurs des séquences agissent sur la région à examiner dont chacune comprend au moins trois impulsions à haute fréquence, où l'écart entre les deux premières impulsions à haute fréquence (HF₁, HF₂) est égal à la valeur inverse du double de la constante de liaison scalaire J des composantes de lactate reliées l'une à l'autre et où, entre ou après les impulsions à haute fréquence, des champs à gradients magnétiques (Gx) agissent avec une amplitude et une durée telles que les signaux de résonance magnétique nucléaire agissant après la troisième impulsion à haute fréquence ne sont déterminés que par la cohérence à double quantum,
caractérisé en ce que l'unité de commande pour la réalisation du procédé suivant la revendication 2 est programmée de telle sorte que la troisième impulsion à haute fréquence (HF₃) soit sélective sur le plan de la fréquence de telle sorte qu'elle agisse comme une impulsion à 90° pour la composante de lactate (M₂) provenant du radical CH et comme une impulsion à 180° pour la composante de lactate (M₁) provenant du radical CH₃.
